**Europäisches Patentamt**

**European Patent Office**

**Office européen des brevets**

(19)

(11) Numéro de publication : **0 480 790 A2**

## (12) DEMANDE DE BREVET EUROPEEN

(21) Numéro de dépôt : **91402570.5**

(22) Date de dépôt : **26.09.91**

(51) Int. Cl.$^5$ : **G11C 19/08**

(30) Priorité : **28.09.90 FR 9012008**

(43) Date de publication de la demande :
**15.04.92 Bulletin 92/16**

(84) Etats contractants désignés :
**DE GB**

(71) Demandeur : **COMMISSARIAT A L'ENERGIE ATOMIQUE**
**31-33, rue de la Fédération**
**F-75015 Paris (FR)**

(72) Inventeur : **Arnaud, Lucile**
**Les Michallons**
**F-38250 St Nizier de Moucherotte (FR)**
Inventeur : **Youssef, Ben Jamal**
**1,Boulevard Jourdan**
**F-75014 Paris (FR)**
Inventeur : **Challeton, Didier**
**14 rue de la Richarde**
**F-38120 Saint Egreve (FR)**
Inventeur : **Miltat, Jacques**
**45 Boulevard Dubreuil**
**F-91400 Orsay (FR)**

(74) Mandataire : **Lhoste, Catherine et al**
**BREVATOME 25, rue de Ponthieu**
**F-75008 Paris (FR)**

(54) **Mémoire magnétique à lignes de Bloch.**

(57)     Cette mémoire comporte un film magnétique (2) d'épaisseur h, disposé sur un substrat (4) et contenant des lignes de BLoch (8a, 8b) de largeur $\Lambda$o, caractérisée en ce que le film magnétique satisfait à la condition

$$(1) \quad h/\Lambda o < 14 \quad avec \quad \Lambda o = \sqrt{A/2\pi M s^2},$$

où A représente la constante d'échange magnétique et $4\pi Ms$ représente l'aimantation du film à la saturation.

FIG. 1

L'invention se rapporte à une mémoire magnétique à lignes de Bloch permettant la mémorisation d'informations binaires.

Le principe de la mémoire à lignes de Bloch a été proposé en 1983 par S. Konishi dans le document EP-A-0106358 et l'article de IEEE Transactions on Magnetics, vol. MAG19 (1983) n°5, p.1838-1840 : "A new ultra-high density solid state memory : Bloch line memory".

Les mémoires à lignes de Bloch utilisent le même matériau que les mémoires magnétiques à bulles mais elles présentent une densité de stockage beaucoup plus grande que celle des mémoires à bulles.

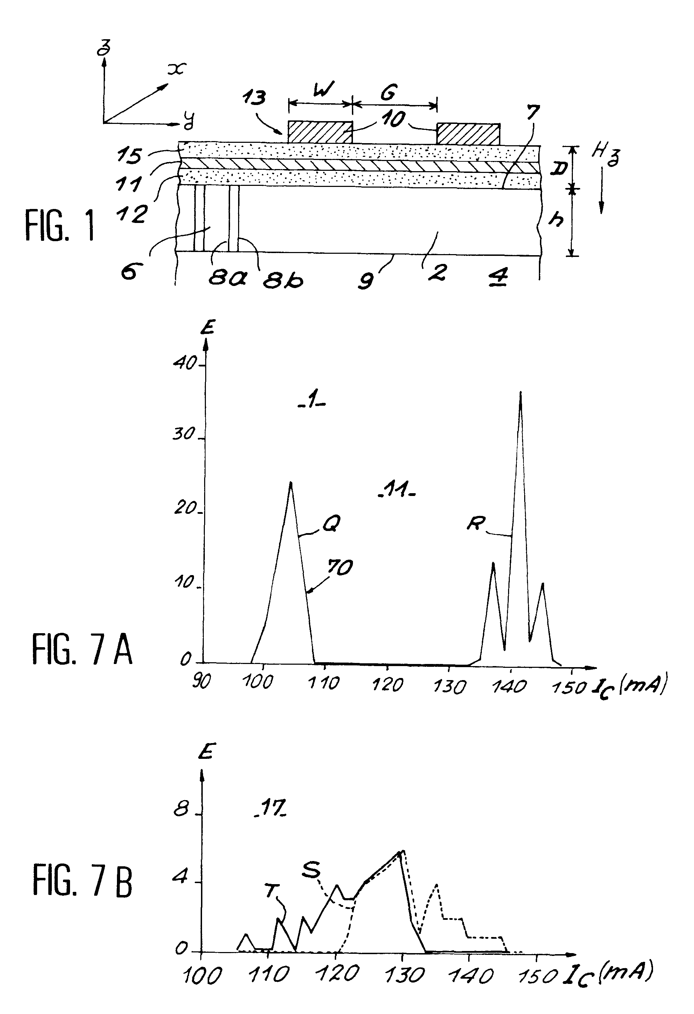

Les mémoires à lignes de Bloch comprennent de façon connue, comme schématisé en coupe sur la figure 1, un film magnétique 2 d'épaisseur $\underline{h}$, disposé sur un substrat 4 amagnétique généralement de grenat de gallium et de gadolinium (GGG). La surface principale 7 du film magnétique 2 est parallèle au plan xy et son axe de facile aimantation F est orienté selon l'axe z perpendiculaire à cette surface principale 7.

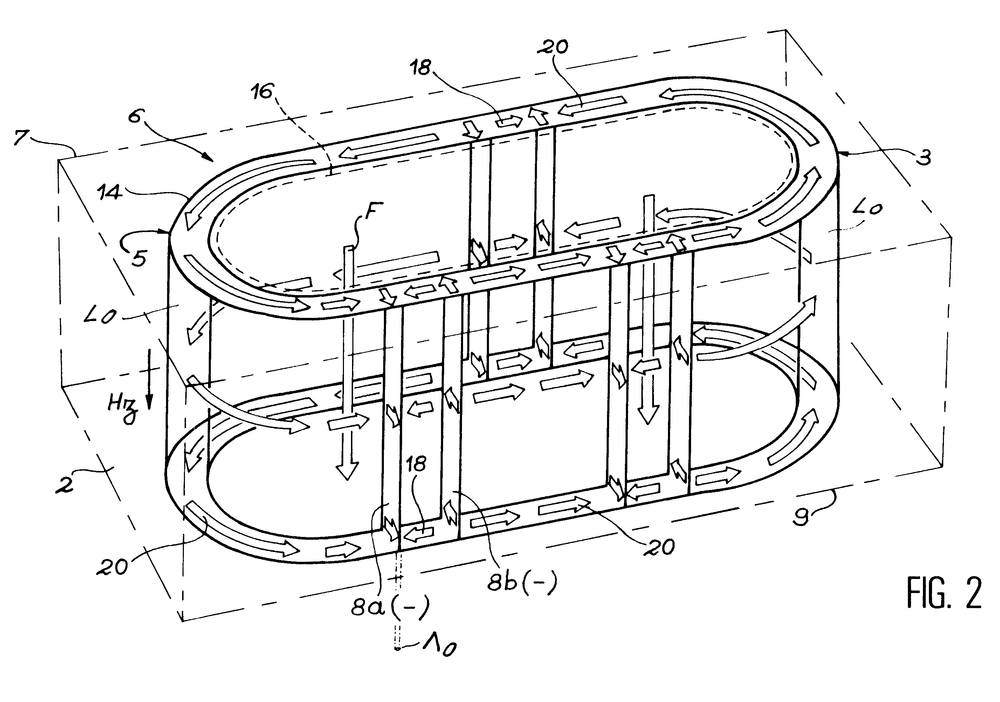

Ce film magnétique 2 contient les domaines en bande 6 et les lignes de Bloch 8a, 8b de la mémoire, représentés de façon plus détaillé sur la figure 2 ; il supporte plusieurs niveaux de conducteurs électriques tels que 11 et 13, nécessaires au fonctionnement de la mémoire. En particulier le niveau supérieur 13 comporte des conducteurs de coupe 10 des domaines en bande.

Ces conducteurs de coupe sont utilisés aussi bien pour la lecture que pour l'écriture d'une information. Ils permettent en particulier de discriminer une coupe facile d'une coupe difficile des domaines en bande suivant la présence ou non d'une paire de lignes de Bloch, correspondant respectivement à l'information "1" ou "0". Cette discrimination de coupe est donc l'une des opérations essentielles d'une mémoire magnétique à lignes de Bloch.

Un isolant électrique 12, appelé espaceur est prévu entre les conducteurs électriques du niveau inférieur et le film magnétique 2. De même, un isolant électrique 15 ou espaceur est prévu entre les différents niveaux de conducteurs. On note D la distance séparant les conducteurs de coupe 10 et le film 2.

Chaque domaine en bande 6 est entouré d'une paroi 14 d'une certaine épaisseur et leur "stabilisation" dans le film magnétique est assurée par des zones de stabilisation 16 formées en particulier par implantation ionique ou par gravure du film 2, sur toute son épaisseur.

La stabilisation des domaines en bande est notamment décrite dans l'article de H. Kawahara et al. IEEE Transactions on Magnetics vol.MAG.23, n°5, de septembre 1987, p.3396-3398, "A new method to stabilize multi-stripe domains for a Bloch line memory".

Les flèches 18 et 20 représentent l'aimantation de la paroi 14 et leur orientation depend de l'information contenue dans le domaine 6 ; les flèches 18 sont orientées selon le sens de rotation des aiguilles d'une montre et les flèches 20 sont orientées selon le sens inverse. L'aimantation dans les domaines en bande est opposée à celle du reste du matériau magnétique.

Les lignes de Bloch apparaissent à chaque fois que l'aimantation dans la paroi 14 change de sens et sont perpendiculaires à la surface 7 du film 2. Les lignes de Bloch vont toujours par paires, une ligne 8a et une ligne 8b et doivent être de signe négatif pour le fonctionnement de la mémoire.

Pour une paire de lignes de Bloch 8a et 8b, l'aimantation dans la section de paroi 18 entre les deux lignes est de sens opposé à l'aimantation du reste de la paroi 20.

Le signe d'une ligne 8a, 8b correspond non pas au sens des flèches représentées sur les figures mais au sens de rotation de l'aimantation au passage de la ligne à partir de la paroi.

Quelle que soit l'orientation de l'aimantation dans un domaine, on définit une ligne de Bloch +, si la rotation de l'aimantation au passage de la ligne s'ajoute à la rotation de l'aimantation dans la paroi du domaine et on définit une ligne de Bloch lorsque les rotations de ces deux aimantations sont opposées.

Les domaines en bande 6 comportent deux extrémités respectivement 3 et 5 appelées première et seconde têtes de bande. Ils sont extensibles et rétractables dans une direction passant par ces deux extrémitées 3 et 5 lorsqu'on leur applique un champ magnétique continu de commande $\overrightarrow{H_z}$, approprié, selon la direction z et orienté de la surface supérieure 7 du film vers sa surface inférieure 9. Généralement, même lorsque les domaines ne renferment aucune information "1" une ligne de Bloch négative à chaque extrémité du domaine en bande est inscrite et positionnée au préalable au fonctionnement de la mémoire.

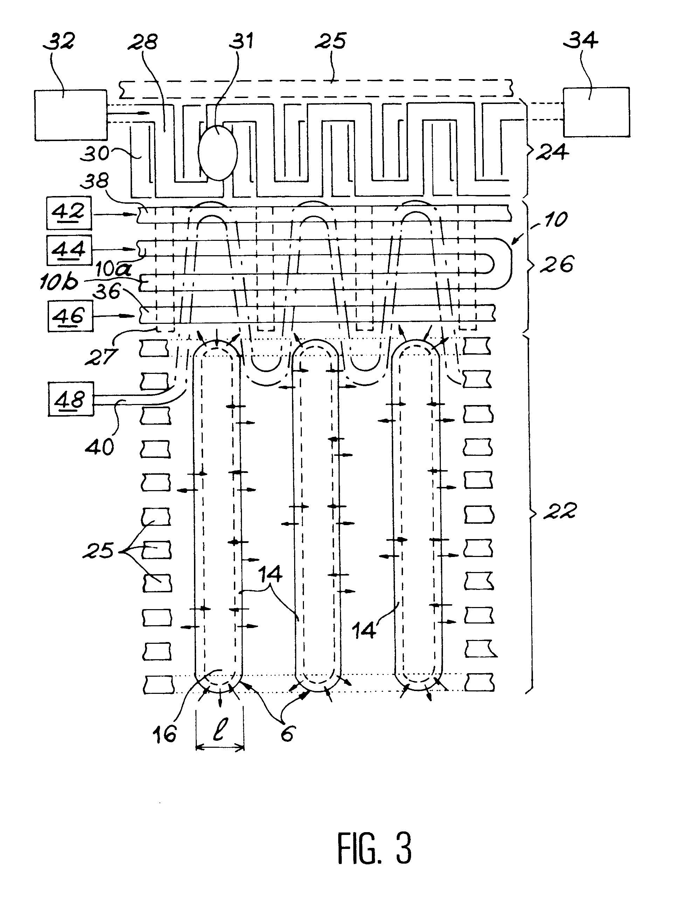

L'organisation d'une mémoire à lignes de Bloch est similaire à celle d'une mémoire à bulles. Cette organisation est représentée schématiquement sur la figure 3. Elle comprend une zone de stockage 22, une zone d'accès 24 et des portes de transfert 26 entre la zone de stockage et la zone d'accès.

La zone de stockage est constituée des domaines en bande 6, parallèles entre eux, dont les parois 14 jouent le rôle de boucles mineures. La stabilisation des lignes et des domaines est assurée par des motifs de trame 25 perpendiculaires aux domaines et des motifs de trame 16 et 27 parallèles aux domaines.

La zone d'accès 24 comporte généralement deux conducteurs 28 et 30 isolés, disposés en chevron, un générateur 32 et un détecteur 34 de bulles magnétiques 31 à proximité de ces conducteurs.

Les informations "1" et "0" correspondent respectivement à la présence ou à l'absence d'une paire 8a-8b de lignes de Bloch dans la zone de stockage. En général, la présence et l'absence d'une bulle 31 dans la zone d'accès 24 correspondent respectivement aux informations "1" et "0" pour la lecture et à l'inverse pour l'écriture.

A l'entrée, les signaux électriques d'écriture sont convertis en information magnétique par le générateur 32. L'information est stockée dans la zone d'accès jusqu'à son remplissage. Un transfert en parallèle grâce aux portes de transfert 26 fait passer l'information de la zone d'accès vers les domaines en bande. A l'écriture, la nouvelle information doit remplacer l'ancienne ; l'écriture s'accompagne donc d'un effacement.

Pour la lecture, l'information contenue dans les domaines en bande 6 est transférée dans la zone d'accès pour être détectée ; l'information contenue dans la zone de stockage ne doit pas être détruite. Pour accéder à une information donnée, il faut que les éléments binaires correspondant se trouvent en face des portes de transfert 26.

Ces portes de transfert doivent réaliser deux fonctions : l'échange d'informations lors de l'écriture et la "duplication" lors de la lecture.

De façon connue, les portes de transfert 26 comportent un conducteur de contrôle 36, un dispositif de coupe 10 des domaines en bande, un conducteur d'écriture 38 des paires de lignes de Bloch, distinct du dispositif 10 et des conducteurs d'extension 40 des domaines en bande. Le dispositif de coupe peut consister en une épingle conductrice parcourue par un courant ou en deux bandes conductrices parallèles entre elles, parcourues par des courants de même intensité mais de sens opposé. Les références 10a et 10b représentent les deux bandes conductrices (ou les deux branches de l'épingle) du dispositif de coupe.

Le conducteur d'écriture 38 peut avoir la forme d'une bande comme représenté ou la forme d'une épingle. Par ailleurs, ce conducteur 38 peut être confondu avec le dispositif de coupe 10. Dans ce dernier cas, le dispositif de coupe 10 sert à la fois à la lecture et à l'écriture.

Tous ces conducteurs électriques sont isolés électriquement les uns des autres ; leurs formes et leur disposition respectives sont variables. En général les conducteurs d'extension constituent le premier niveau 11 de conducteurs et les conducteurs 36, 38 et 10 constituent les autres niveaux 13. Les conducteurs 38, 10, 36 et 40 sont connectés respectivement à des sources d'alimentation électrique 42, 44, 46 et 48.

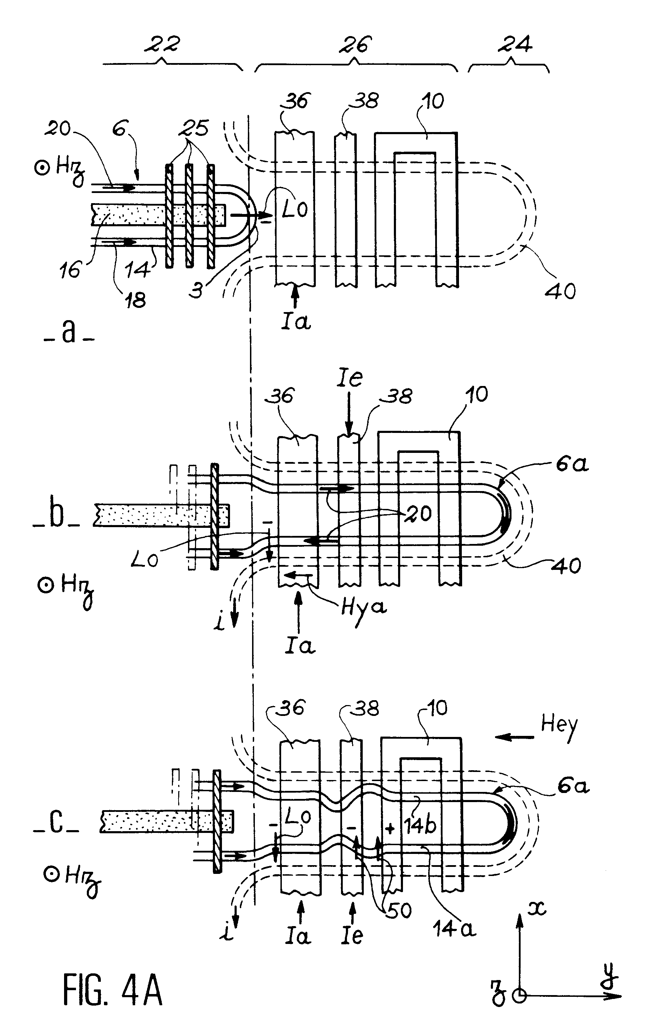

L'écriture d'une paire de lignes de Bloch (-, -) correspondant à l'information "1" (ou transfert in) nécessite différentes phases représentées sur les figures 4A-4B.

Sur la partie $\underline{a}$ de la figure 4A, le domaine en bande 6 est au repos, sa paroi 14 entoure la zone 16 de stabilisation. Un aimant permanent extérieur crée par exemple le champ de polarisation $\overrightarrow{Hz}$. Des motifs 25, orientés perpendiculairement au domaine 6 permettent de fixer la position des lignes. La ligne de Bloch de l'extrémité 3 du domaine en bande est notée Lo ; elle est toujours de signe -.

La première phase de l'écriture, représentée sur la partie b de la figure 4A, consiste à étendre le domaine en bande sous les conducteurs électriques 36, 38 et 10 par application d'un courant i approprié sur le conducteur d'extension 40. Ce courant i sera appliqué pendant toute la durée de l'écriture.

Simultanément avec l'extension, le conducteur de contrôle 36 est activé par un courant Ia ; le champ magnétique plan $\overrightarrow{Hya}$ créé sous ce dernier bloque la ligne Lo d'extrémité ; ce courant Ia sera appliqué pendant toute la durée de l'écriture. Le domaine en bande étendu porte la référence 6a.

On effectue ensuite l'écriture à proprement parler de la paire de lignes de Bloch (-,-).

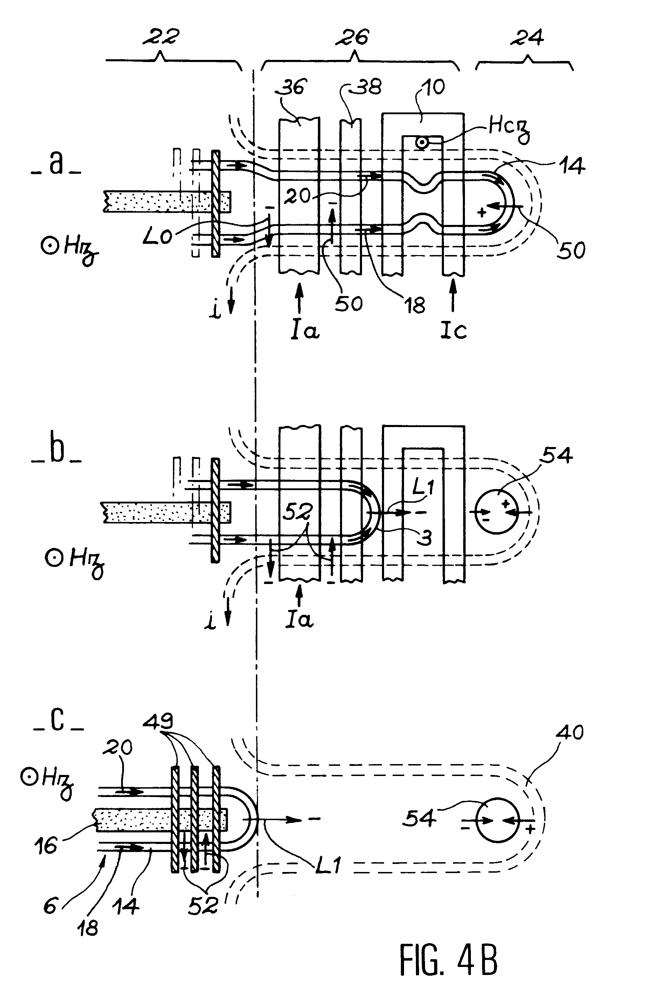

Pour ce faire, on écrit tout d'abord une paire de lignes (+, -) instable (partie C de la figure 4A) que l'on convertit ensuite en paire (-, -) stable (parties $\underline{a}$ et $\underline{b}$ de la figure 4B).

En envoyant de façon connue une impulsion de courant Ie d'environ 70 mA pendant 40 ns avec des temps de montée et de descente de 10 ns dans le conducteur d'écriture 38, le champ magnétique créé localement est suffisant pour que des boucles de Bloch horizontales soient créées. Si le courant Ie est maintenu (de 10 à 100 ns suivant les films magnétiques 2 considérés), les boucles produites "percent" et des paires de lignes de Bloch 50 de polarités opposées (+, -) sont nucléées dans la paroi 14 du domaine étendu 6a (partie $\underline{c}$ de la figure 4A).

En fait, le courant Ie déplace localement la paroi 14 du domaine. Si la vitesse de déplacement local de la paroi 14 est égale ou supérieure à la vitesse v°n de nucléation (vitesse qui ne dépend que des paramètres du film magnétique 2), il y a nucléation des boucles de Bloch dans les parties latérales 14a ou 14b de la paroi traversées par le conducteur d'écriture 38, à la surface du film 2 ou à l'interface 2-11 film-conducteur. La nucléation d'une seule paire correspondant à la seule paire (+, -) 50 est possible si on applique un champ plan extérieur $\overrightarrow{Hey}$. Seule la paroi dont l'aimantation est opposée au sens du champ $\overrightarrow{Hey}$ aura une vitesse suffisante pour permettre la nucléation d'une boucle de Bloch. En présence du champ plan $\overrightarrow{Hey}$, immédiatement après écriture, les lignes 50 sont séparées et la ligne + se retrouve repoussée vers l'extrémité 3 (figure

3

4B).

Pour convertir la paire (+, -) de lignes 50 en une paire (-, -) 52 stable, on réalise alors une coupe du domaine en bande 6a (partie a de la figure 4B) en appliquant une impulsion de courant Ic au conducteur 10 ici en épingle, créant un champ magnétique local vertical $\overrightarrow{H c z}$ entraînant un déplacement local des parois 14a et 14b l'une vers l'autre.

Par continuité topologique du vecteur aimantation, une ligne négative L1 est produite à l'extrémité 3 du domaine 6a qui vient d'être coupé (partie b de la figure 4B).

La bulle magnétique 54 issue de la coupe du domaine 6a, doit être évacuée dans la zone d'accès et détruite car elle n'est le support d'aucune information (partie c de la figure 4B).

D'autres schémas peuvent être considérés pour l'écriture. Par exemple, un principe proposé par Hitachi dans le document EP-A-0255044, repose sur l'hypothèse d'écriture directe de paires de lignes de Bloch négatives par production d'un point de Bloch.

Dans l'invention, on utilise le principe décrit aux figures 4A, 4B.

Le retour au repos du domaine en bande 6 (partie c de la figure 4B) est obtenu en supprimant le courant appliqué au conducteur d'extension. Parallèlement, le courant appliqué au conducteur de contrôle 36 est supprimé.

Comme on l'a dit précédemment, la vitesse de nucléation v°n des lignes de Bloch dépend des paramètres du film magnétique 2. On peut l'exprimer de la façon suivante :

$$v°n \ = \ 24a.A/h \ \sqrt{ku}$$

avec a le facteur gyromagnétique du film, A la constante d'échange magnétique, h l'épaisseur du film magnétique et Ku la constante d'anisotropie uniaxiale.

Cette vitesse de nucléation est modifiée en présence d'un champ magnétique plan $\overrightarrow{H y}$ comme suit :

$$vn \ = \ v°n \ + \ \mathcal{E}.\pi/2.a. \ \sqrt{A/Ku}.\overrightarrow{H y}$$

avec ε=+1 si l'aimantation du film 2 et le champ $\overrightarrow{H y}$ sont de même sens et ε=-1 si l'aimantation et le champ $\overrightarrow{H y}$ sont de sens contraires.

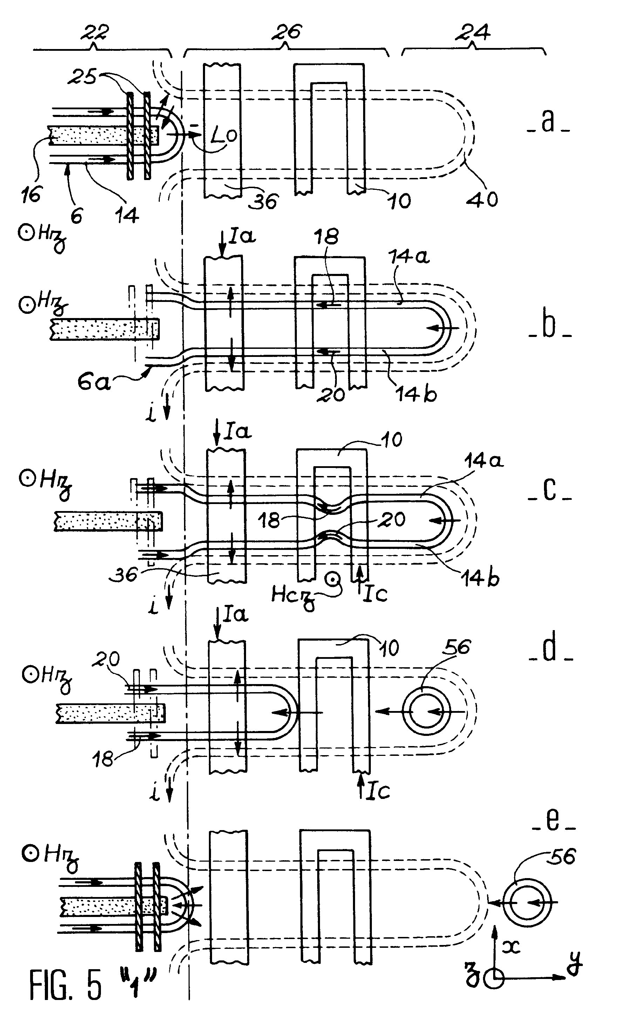

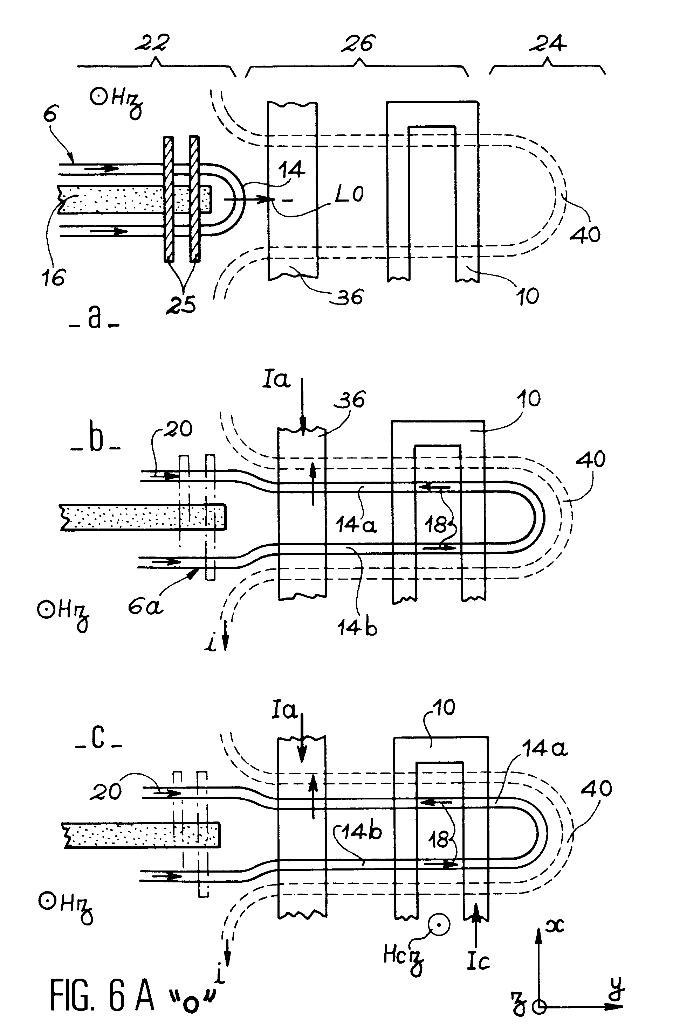

Le principe de la lecture des informations "1" et "0" stockées dans les domaines en bande est représenté respectivement sur les figures 5 et 6A-6B. La lecture d'une information, appelée aussi transfert out, comporte plusieurs étapes.

Sur la partie a des figures 5 et 6A, le domaine en bande 6 est au repos.

La lecture d'une information ne nécessite que trois types de conducteurs électriques au lieu de quatre dans certains cas pour l'écriture ; un conducteur d'extension 40, un conducteur de coupe 10 et un conducteur de contrôle 36.

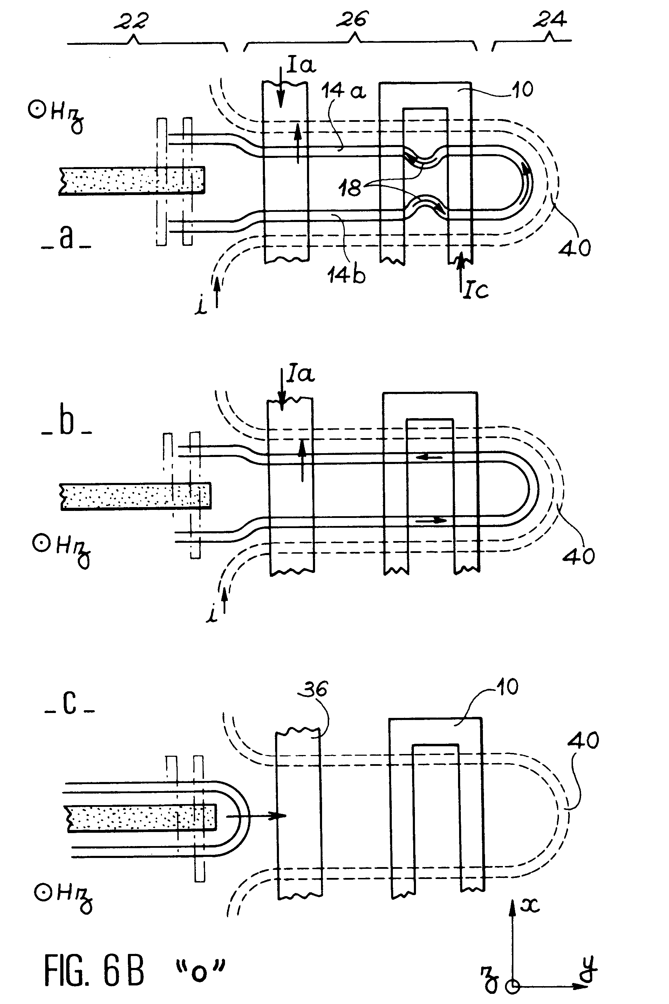

Comme pour l'opération de transfert in, la lecture nécessite d'abord l'extension du domaine en bande 6 de la zone de stockage 22 vers la zone de transfert 26 (partie b des figures 5 et 6A), puis la lecture proprement dite des paires de lignes de Bloch (parties c des figures 5 et 6A et a et b de la figure 6B).

La lecture d'un élément binaire se fait par la discrimination entre une coupe facile (figure 5) et une coupe difficile (figures 6A-6B) du domaine en bande 6a. Cette lecture est une duplication, car après l'opération de lecture, l'état du domaine 6 est le même que l'état initial.

Pendant toute l'opération de lecture, un courant i approprié est maintenu dans le conducteur d'extension 40.

Au moment de l'extension du domaine en bande 6a, un courant Ia est appliqué dans le conducteur de contrôle 36 et maintenu pendant toute l'opération de lecture afin de bloquer les lignes de Bloch du domaine 6a, et d'obtenir les deux structures de paroi de référence :

– paroi à aimantation parallèle pour la coupe facile en présence d'une paire de lignes de Bloch (figure 5) ;
– paroi à aimantation antiparallèle pour la coupe difficile en l'absence d'une paire de lignes de Bloch (figures 6A, 6B).

Ensuite on applique une impulsion de courant Ic (parties c des figures 5 et 6A) sur le conducteur de coupe 10. La présence de lignes de Bloch permet une coupure à courant faible du domaine en bande, conduisant à la formation d'une bulle 56 qui peut être lue par le détecteur de bulles 34 alors que l'absence de lignes de Bloch ne permet la coupure du domaine en bande qu'avec des courants plus élevés que celui nécessaire à la coupe facile.

L'application du courant Ic sur le conducteur de coupe 10 crée un champ magnétique local $\overrightarrow{Hcz}$. Lorsque le conducteur en épingle est positionné perpendiculairement au domaine 6a à tester et si le champ $\overrightarrow{Hcz}$ local s'ajoute au champ de polarisation $\overrightarrow{Hz}$ du domaine 6a, il est possible de couper le domaine ; si les aimantations 18 et 20 des parois 14a et 14b pointent dans la même direction, sous l'épingle de coupe, il est facile de couper le domaine par celle-ci (figure 5). Si les aimantations des parois 14a et 14b pointent dans des directions opposées sous l'épingle de coupe, il est difficile de couper le domaine par celle-ci (figure 6A).

Le retour au repos du domaine en bande est encore obtenu en supprimant les courants appliqués aux conducteurs d'extension et de contrôle (parties e et c des figures 5 et 6B)

On définit la marge de coupe comme étant la différence entre le courant élevé nécessaire à la coupe difficile et le courant plus faible nécessaire à la coupe facile.

On considère qu'on n'obtient pas de marge de coupe si on a un recouvrement des répartitions en courant des deux types de coupe pour l'ensemble des domaines en bande de la mémoire. En revanche, on obtient une marge de coupe lorsque les répartitions en courant des deux types de coupe pour l'ensemble des domaines sont disjointes.

Aussi, pour qu'une mémoire à lignes de Bloch fonctionne, il faut qu'elle satisfasse à la fonction "lecture", c'est-à-dire discrimine les coupes faciles des coupes difficiles des domaines, et donc présente une marge de coupe, appelée aussi marge de lecture.

L'invention a justement pour objet une mémoire à lignes de Bloch permettant l'obtention d'une marge de coupe lors de la lecture des lignes (transfert-out ou duplication) et lors de la conversion paire (+,-) en paire (-,-) dans l'écriture des paires de lignes (transfert-in).

Le demandeur a trouvé que le film magnétique devait satisfaire à une condition particulière pour obtenir cette marge de coupe.

Aussi, l'invention se rapporte à une mémoire à lignes de Bloch comportant un film magnétique d'épaisseur h, disposé sur un substrat et contenant des lignes de Bloch de largeur $\Lambda o$, caractérisée en ce que le film magnétique satisfait à la condition (1) $h/\Lambda_o < 14$ avec

$$(1) \quad h/\Lambda o < 14 \quad avec \quad \Lambda o = \sqrt{A/2\pi M_s^2},$$

où A représente la constante d'échange magnétique et $4\pi Ms$ représente l'aimantation du film à la saturation ; généralement le film magnétique est épitaxié sur un substrat monocristallin.

Le film magnétique utilisé est l'un de ceux généralement utilisés dans les mémoires à bulles. On peut par exemple utiliser des films de grenat ferrimagnétiques tels que ceux décrits dans le document FR-A-2 587 734 ou ceux présentant la formule (2) suivante :

$$(TR_3) (FeX)_5 O_{12} \quad (2)$$

où TR représente au moins un élément choisi parmi Y, Sm, Lu, Bi, Ca, Gd, Pr et Yb et X représente au moins un élément choisi parmi Al, Ga, Si et Ge.

De façon que la marge de coupe soit relativement élevée, la mémoire de l'invention comporte avantageusement un dispositif de coupe des domaines en bande satisfaisant à certaines conditions.

Ce dispositif de coupe est soit du type en épingle, soit constitué de deux bandes conductrices parallèles. Il peut être utilisé dans les différentes configurations décrites précédemment, c'est-à-dire associé à un conducteur de contrôle et à un conducteur d'écriture ou à un conducteur de contrôle seul. Il peut en outre être utilisé dans une structure à deux ou à trois niveaux de conducteurs.

Ce dispositif de coupe servant à l'écriture ou à la lecture d'une information dans la mémoire comporte deux bandes conductrices de l'électricité parallèles de largeur au plus W, supportées par le film magnétique contenant les domaines en bande et orientées perpendiculairement aux domaines, ces bandes conductrices étant espacées l'une de l'autre d'une distance G et séparées du film magnétique par une distance D, et des moyens d'alimentation pour appliquer une première impulsion de courant simultanément sur les deux bandes conductrices, les paramètres I, W, G et D satisfaisant aux relations suivantes : $1 \leq I/D \leq 6$ ; $I/G \geq 1,1$ ; et $I/W \geq 1,3$, avec I représentant la largeur des domaines en bande.

Ce dispositif de coupe permet d'écrire l'information "1" dans la mémoire, par écriture (ou nucléation) d'une paire de lignes de Bloch et d'écrire l'information "0" par effacement d'une paire de lignes de Bloch. Il permet en outre la lecture des informations stockées dans les domaines en bande sans risque de les détruire.

Afin d'empêcher toute création de lignes de Bloch inopportune lors de la coupe du domaine en bande, les moyens d'alimentation des deux bandes conductrices délivrent une première impulsion de courant ayant un temps de montée Tm supérieur au temps de montée To qu'aurait une seconde impulsion de courant minimum nécessaire à la nucléation des lignes de Bloch.

Ce temps de montée To minimum nécessaire à la nucléation des lignes de Bloch a été déterminé par les inventeurs ; il satisfait à l'équation (3) suivante :

$$To=(\vec{Hcz}/vn).(h/8Ms/\ln(1+h^2/l^2)) \qquad (3)$$

dans laquelle $\vec{Hcz}$ est la valeur du champ magnétique créée dans le film par la première impulsion selon une direction perpendiculaire à la surface du film ; h est l'épaisseur du film magnétique ; ln est le logarithme népérien ; Ms est l'aimantation à saturation du film magnétique et vn est la vitesse de nucléation des lignes de Bloch avec

$$vn=(24a.A/h\sqrt{Ku})+\xi.\pi/2.a\sqrt{A/Ku}.\vec{Hy}$$

où $\underline{a}$ est le facteur gyromagnétique du film magnétique ; A est la constante d'échange magnétique ; Ku est la constante d'anisotropie uniaxiale du film magnétique ; $\vec{Hy}$ est le champ créé dans le plan du film au moins en partie par la première impulsion et ε vaut +1 respectivement -1, lorsque l'aimantation magnétique de la paroi du domaine et le champ $\vec{Hy}$ sont respectivement de même sens et de sens opposé.

Pour toute impulsion de temps de montée Tm>To, la paroi du domaine se propage à une vitesse inférieure à vn ; il n'y a donc pas de lignes de Bloch nucléées lors de l'opération de coupe.

Pour toute impulsion de temps de montée Tm<To, la paroi du domaine se propage à une vitesse égale à vn et il y a nucléation de lignes de Bloch. En particulier, Tm vaut environ 2To.

L'équation (3) ci-dessus de To n'est vraie que pour les films magnétiques pour lesquels To est >>Ts avec Ts=h/8Ms.u, où u vaut a/b. $\sqrt{A/ku}$ (b = coefficient d'amortissement et vaut 0,1 pour les compositions utilisées). En général, Ts est de l'ordre de 10ns alors que To vaut plusieurs dizaines de nanosecondes.

Selon l'invention, $\vec{Hy}$ représente le champ plan $\vec{Hcy}$ seul correspondant à la composante dans le plan xy du champ induit dans le film magnétique par le courant lc parcourant le conducteur de coupe, ou additionné d'un champ extérieur supplémentaire supplémentaire $\vec{Hey}$ appliqué le long du domaine en bande, lors de la coupe, si nécessaire.

La description de l'invention se réfère aux dessins annexés dans lesquels :
– la figure 1, déjà décrite, représente en coupe une partie d'une mémoire à lignes de Bloch, montrant l'agencement des conducteurs de coupe sur le film magnétique ; ,
– la figure 2, déjà décrite, représente un domaine en bande, en perspective, de la mémoire de la figure 1 ;
– la figure 3, déjà décrite, représente en vue de dessus l'organisation d'une mémoire à lignes de Bloch ;
– les figures 4A, 4B, déejà décrites, représentent les différentes phases de l'écriture d'une paire de lignes de Bloch dans une mémoire à lignes de Bloch ;
– les figures 5 et 6A, 6B, déjà décrites, représentent respectivement les différentes phases de la lecture d'une information "1" et "0" dans une mémoire à lignes de Bloch ; et
– les figures 7A et 7B donnent la répartition en courant des deux types de coupe pour l'ensemble des domaines en bande pour respectivement un échantillon satisfaisant à la condition (1) et ne satisfaisant pas à cette condition.

Conformément à l'invention, le film magnétique d'une mémoire à lignes de Bloch doit remplir la condition

$$(1) \quad h/\Lambda o<14 \quad avec \quad \Lambda o=\sqrt{A/2\pi Ms^2},$$

pour que la mémoire satisfasse à la fonction "lecture" ; h représente l'épaisseur du film magnétique (figure 1) et $\Lambda o$ la largeur d'une ligne de Bloch (figure 2).

Plusieurs échantillons ont été étudiés. Ils se composaient d'un film de grenat ferrimagnétique épitaxié sur un monocristal de grenat de gallium et de gadolinium. Ces films présentaient différentes compositions ainsi que différentes valeurs de A, h et 4πMs. Les résultats expérimentaux sont donnés dans le tableau I ci-joint ; ils sont en accord avec la condition (1).

Pour tester ces échantillons, on a utilisé un conducteur de coupe des domaines en bande en forme d'épingle, disposé perpendiculairement aux domaines en bande. La largeur W des branches de l'épingle valait 2μm, la distance G (ou gap) séparant ces deux branches valait 2μm, la distance D séparant le conducteur de coupe du film ferrimagnétique était de 3µm et la largeur l des domaines en bande valait 5,4µm. W, G et D sont représentés sur la figure 1 et l sur la figure 3.

Le test consiste à préparer soit des domaines à coupe facile (figure 5) soit des domaines à coupe difficile (figures 6A-6B). Pour chacun des domaines (parfaitement identifié), on mesure le courant de coupe Ic. La mesure de Ic se fait en incrémentant pas à pas le courant appliqué à l'épingle et en notant la valeur de I qui coupe le domaine Ic. Dans toutes les expériences, l'impulsion de courant est triangulaire avec un temps de montée Tm égal au temps de descente de 350ns. On peut donc tracer des histogrammes de coupe.

On considère qu'un échantillon possède une marge de lecture si la répartition des courants de coupe facile de l'ensemble des domaines en bande est disjointe de la répartition des courants de coupe difficile de l'ensemble des domaines en bande (figure 7A). Il n'y a pas de marge de lecture si les deux répartitions se recouvrent (figure 7B).

Si la marge de coupe est suffisante (>à 1mA), l'échantillon est un bon candidat pour les mémoires à lignes de Bloch.

La figure 7A donne la répartition en courant des deux types de coupe pour l'ensemble des domaines en bande de l'échantillon 1 et la figure 7B donne celle de l'échantillon 17 ; E est le nombre d'événements et Ic (en mA) est l'intensité de courant appliquée au conducteur de coupe. Les répartitions Q et T sont relatives à des coupes "faciles" et les répartitions R et S sont relatives à des coupes "difficiles".

Les répartitions en courant Q et R de l'échantillon 1 sont disjointes et la marge de coupe est de 25mA environ. Elle est plus que suffisante et cet échantillon 1 est un bon candidat pour la réalisation d'une mémoire à lignes de Bloch.

En revanche, les répartitions en courant T et S de l'échantillon 17 se chevauchent ; il n'y a pas de marge de coupe. Cet échantillon n'est donc pas utilisable pour une mémoire à lignes de Bloch.

On donne ci-après, les méthodes de mesure utilisées pour l'établissement du tableau 1.

a) - Mesure de l'épaisseur du film h

Cette mesure est réalisée à l'aide d'un spectrophotomètre à longueurs d'onde variables. Le film magnétique de grenat est considéré comme une lame à faces parallèles ; il introduit une différence de marche e, entre le faisceau lumineux réfléchi sur la suface film-air et le faisceau lumineux réfléchi sur la surface film-substrat.

Le maximum d'intensité lumineuse est obtenu lorsque $e=2nh=k\lambda$ , où n est l'indice du film, à la longueur d'onde $\lambda$ et k est un nombre entier. L'incidence du faisceau est pratiquement normale au film.

Le défilement de la longueur d'onde entre deux valeurs $\lambda 1=0,68µm$ et $\lambda 2=0,51µm$ fait apparaître un nombre de maximums d'intensités lumineuses, N, tel que :

$$N = k2-k1 = (e2/\lambda 2 = e1/\lambda 1),$$

d'où l'expression de l'épaisseur :

$$h=N/2 \left[ n_{0,51}/0,51-n_{0,68}/0,68 \right] .$$

La valeur des indices dépend du type de composition. A partir des valeurs mesurées par optique guidée à $\lambda=0,63µm$, $n_{0,63}$ et $\lambda=1,15µm$, $n_{1,15}$, on calcule les valeurs $n_{0,51}$ et $n_{0,68}$ (voir thèse présentée à l'INP de Grenoble par Mr. Hubert Moriceau, intitulée "Elaboration de films de grenat magnétique par épitaxie en phase liquide et caractérisation des films pour mémoire à bulles de grande capacité" du 31/10/81. On note, par exemple, le tableau II ci-joint.

La précision de cette mesure est d'environ 5% pour des épaisseurs h de l'ordre de 1µm.

Pour des épaisseurs plus fines, $0,4µm<h<0,7µm$, on peut effectuer des mesures par optique guidée et pour des films très minces, $h<0,4µm$ on peut utiliser des mesures par ellipsométrie.

b) - Calcul de l'aimantation $4\pi Ms$

L'aimantation se calcule à partir de la mesure de champ de collapse des bulles $\overrightarrow{Hco}$ et de la valeur de la longueur caractéristique lc des bulles avec la formule :

$$4\pi Ms = \overrightarrow{Hco} \left( lc + \frac{3}{4} \frac{lc}{h} - \sqrt{\frac{3lc}{h}} \right)^{-1}$$

l'aimantation ainsi calculée est précise à environ 10%.

c) - Calcul de la longueur caractéristique lc

On utilise la formulation de Fowlis et Shaw suivante :

$$\frac{lc}{h} = \frac{(2l/h)^2}{\pi^3} \sum_n \frac{1}{n^3} \left[ 1 - \exp\frac{-n\pi h}{l} \left( 1 + \frac{n\pi h}{l} \right) \right]$$

d) - Mesure de la largeur l des domaines

Les films de grenat ont une aimantation perpendiculaire au plan du film et présentent, en absence de champ magnétique extérieur, une structure de domaines linéaires. Deux domaines adjacents ont alors leurs aimantations anti-parallèles.

Une lumière polarisée rectilignement, traversant le film perpendiculairement à sa surface, subit une deviation de son axe de polarisation de $+\theta$ ou $-\theta$ suivant le sens de l'aimantation dans le domaine magnétique. Un analyseur placé au-delà de l'échantillon, dans le trajet lumineux, permet d'éteindre la lumière ayant traversé un des deux types de domaines. On définit ainsi un contraste Faraday.

En appliquant alors un champ pulsé, perpendiculairement au film, d'amplitude suffisante (en général de quelques centaines de A/m), on provoque un alignement des domaines en bandes parallèles ; le champ est alors diminué doucement puis supprimé, les domaines restent sous forme de bandes parallèles. Une mesure de la largeur d'une vingtaine de bandes permet de déduire la valeur l, de la largeur d'un domaine. La précision de la mesure est d'environ 5% pour des domaines de 1,2$\mu$m.

### e) - Mesure du champ de collapse des bulles $\overrightarrow{Hcd}$

C'est la valeur du champ magnétique de disparition des bulles.

Pour provoquer la disparition des bulles, il est nécessaire d'appliquer, perpendiculairement à la surface du film, un champ magnétique, continu, défavorisant ces bulles. L'observation du film, en lumière transmise polarisée, permet de déterminer précisément la valeur du champ de collapse lorsque les bulles disparaissent brusquement.

f) -Calcul de la constante d'échange A

La constante d'échange est reliée à la température de Curie Tc par la relation :
$$A = 4,15.10^{-14}(Tc-24)/267$$
(A en J.cm$^{-1}$, Tc en °C)

g) -Mesure de la température de Curie Tc

Tc correspond au passage de l'état ferrimagnétique à l'état paramagnétique. Tc varie linéairement avec l'aimantation ou avec la température de sursaturation $\Delta T = Ts - Te$, où Ts est la température de saturation et Te la température d'épitaxie du film ferrimagnétique.

Une méthode originale de mesure de température de Curie a été mise au point par les inventeurs. Lorsque le matériau passe de l'état ferrimagnétique à l'état paramagnétique, le contraste Faraday disparait avec les domaines.

La cellule chauffante utilisée pour cette mesure a une montée en température assurée par un courant alternatif dans une bobine. Dans le même temps, ce courant provoque dans la bobine un champ magnétique pulsé qui met les parois des domaines en vibration, la direction de ce champ étant normale au plan du film.

En montant en température (le champ pulsé étant nettement supérieur au champ coercitif) la disparition du signal lumineux signifie le passage à l'état paramagnétique. La mesure de la température de Curie par cette méthode est précise à ±2°C.

$$T\ A\ B\ L\ E\ A\ U\qquad I$$

| ECHAN-TILLON | COMPOSITION | $h(\mu m)$ | $4\pi Ms$ $(\times 10^{-4}T)$ | $A(Jcm^{-1})$ | $\Lambda o$ $(\mu m)$ | $\dfrac{h}{\Lambda o}$ | marge |
|---|---|---|---|---|---|---|---|
| 1 | $Y_{2,45}Sm_{0,15}Bi_{0,4}Fe_{3,7}Ga_{1,3}O_{12}$ | 2,24 | 118 | $1,71.10^{-14}$ | 0,175 | 12,8 | OUI |
| 2 | " | 1,93 | 107 | " | * | 10,1 | OUI |
| 3 | " | 1,94 | 123 | " | 0,169 | 11,5 | OUI |
| 4 | " | 2,10 | 127 | " | * | 12,9 | OUI |
| 5 | " | 2,21 | 123 | " | 0,169 | 13,1 | OUI |
| 6 | " | 1,94 | 116 | " | * | 12,0 | OUI |
| 7 | " | 2,69 | 138 | " | * | 17,0 | NON |
| 8 | " | 2,47 | 121 | " | * | 14,4 | NON |
| 9 | " | 2,82 | 125 | " | * | 17,2 | NON |
| 10 | " | 2,0 | 114 | " | * | 11,1 | OUI |
| 11 | " | 2,99 | 127 | " | * | 18,0 | NON |
| 12 | " | 2,0 | 112 | " | * | 10,9 | OUI |
| 13 | " | 2,03 | 145 | " | * | 14,1 | NON |
| 14 | $(YSmBi)_3(FeGa)_5O_{12}$ | 2,16 | 147 | $1,71.10^{-14}$ | * | 15,2 | NON |
| 15 | " | 2,38 | 140 | " | * | 23,1 | NON |
| 15 | " | 2,79 | 133 | " | * | 17,2 | NON |
| 17 | " | 3,10 | 147 | " | * | 16,0 | NON |
| 18 | $Y_{1,58}Sm_{0,1}Yb_{0,09}Ca_{0,96}Bi_{0,34}Fe_{4,065}Ge_{0,616}Si_{0,23}O_{12}$ | 2,10 | 200 | $3,05.10^{-14}$ | 0,135 | 15,6 | NON |
| 19 | " | 2,07 | 212 | " | 0,131 | 15,8 | NON |
| 20 | $(GdSmLuBiGa)_3(FeSi)_5O_{12}$ | 2,39 | 325 | $2,88.10^{-14}$ | 0,080 | 29,0 | NON |
| 21 | $(SmLuBi)_3(FeGa)_5O_{12}$ | 3,85 | 185 | $1,80.10^{-14}$ | 0,115 | 33,5 | NON |
| 22 | $(GdPrBi)_3(FeAl)_5O_{12}$ | 2,10 | 128 | $2,90.10^{-14}$ | 0,21 | 9,95 | OUI |
| 23 | " | 2,05 | 144 | " | 0,19 | 10,93 | OUI |

\* VALEURS NON CALCULEES

TABLEAU II
==================

| COMPOSITION | $n_{0,51}$ calculé | $n_{0,63}$ mesuré | $n_{0,68}$ calculé | $n_{1,15}$ mesuré | Facteur N/h |
|---|---|---|---|---|---|
| $(YSmLuCa)_3(FeGe)_5O_{12}$ | 2,32 | 2,235 | 2,2 | 2,155 | 2,57 |
| $(Y)_3(FeGa)_5O_{12}$ | 2,42 | 2,305 | 2,28 | 2,207 | 2,7 |
| $(EuLuCa)_3(FeGe)_5O_{12}$ | 2,32 | 2,246 | 2,22 | 2,164 | 2,70 |
| $(YSmLuBi)_3(FeGa)_5O_{12}$ | 2,43 | 2,331 | 2,31 | 2,234 | 2,75 |

EP 0 480 790 A2

**Revendications**

1. Mémoire à lignes de Bloch comportant un film magnetique (2) d'épaisseur h, dispose sur un substrat (4) et contenant des lignes de Bloch (8a, 8b) de largeur $\Lambda$o, caractérisée en ce que le film magnétique satisfait à la condition

$$(1) \quad h / \Lambda o < 1 4 \quad avec \quad \Lambda o = \sqrt{A / 2 \pi M s^2},$$

où A représente la constante d'échange magnétique et $4\pi Ms$ représente l'aimantation du film à la saturation.

2. Mémoire selon la revendication 1, caractérisée en ce que le film magnétique est un grenat ferrimagnétique.

3. Mémoire selon la revendication 1 ou 2, caractérisée en ce que le film présente la composition (2) suivante :
$$(TR_3)(FeX)_5O_{12} \quad (2),$$
où TR représente au moins un élément choisi parmi Y, Sm, Lu, Bi, Ca, Gd, Pr et Yb et X représente au moins un élément choisi parmi Al, Ga, Si et Ge.

4. Mémoire selon l'une quelconque des revendications 1 à 3, comportant en outre au moins un domaine en bande (6) de largeur l logé dans le film magnétique, un dispositif de coupe (10) de ce domaine consistant en deux bandes conductrices de l'électricité (10a, 10b) parallèles de largeur au plus W, supportées par le film magnétique (2) et orientées perpendiculairement au domaine, ces bandes conductrices étant espacées l'une de l'autre d'une distance G et séparées du film magnétique par une distance D et en des moyens d'alimentation (44) pour appliquer une première impulsion de courant (Ic) simultanément sur les deux bandes conductrices, caractérisée en ce que les paramètres l, W, G et D satisfont aux relations suivantes :
$$1 \leqq l/D \leqq 6 ; l/G \geqq 1,1 ; et\ l/W \geqq 1,3.$$

5. Mémoire selon la revendication 4, caracterisée en ce que les moyens d'alimentation (44) délivrent une première impulsion de courant ayant un temps de montée Tm supérieur au temps de montée To qu'aurait une seconde impulsion de courant minimum nécessaire à la nucléation des lignes de Bloch.

FIG. 1

FIG. 7 A

FIG. 7 B

FIG. 2

EP 0 480 790 A2

FIG. 3

FIG. 4A

FIG. 4 B

FIG. 5 "1"

FIG. 6 A

FIG. 6 B  "o"